# FASCICULE DE BREVET EUROPEEN

(11) **EP 4 066 278 B1**
(45) Date de publication et mention de la délivrance du brevet: **29.07.2026**
(21) Numéro de dépôt: 20820509.6
(22) Date de dépôt: 24.11.2020
(51) Int. Cl.: H10P 72/00, H10P 90/00, H10W 10/10

(54) **PROCEDE DE COLLAGE DE DEUX SUBSTRATS**
VERFAHREN ZUR BINDUNG ZWEIER SUBSTRATE
METHOD FOR BONDING TWO SUBSTRATES

(30) Priorité: 25.11.2019 FR 1913162
(43) Date de publication de la demande: 05.10.2022
(73) Titulaire: SOITEC, 38190 Bernin (FR)
(72) Inventeur: SCHWARZENBACH, Walter, 38190 Bernin (FR); VIRAVAUX, Laurent, 38190 Bernin (FR)
(74) Mandataire: Regimbeau
(86) Numéro de dépôt international: PCT/FR2020/052160
(87) Numéro de publication internationale: WO 2021/105605

(56) Documents cités:
- EP-A1- 1 964 166

## Description

### Domaine de l'invention

L'invention concerne un procédé de collage d'un premier substrat et d'un second substrat.

### Etat de la technique

Les procédés de collage, notamment par adhésion moléculaire, sont largement utilisés dans la fabrication de substrats semi-conducteurs.

En particulier, pour fabriquer des substrats de type semi-conducteur sur isolant, notamment de type silicium sur isolant (SOI, acronyme du terme anglo-saxon « Silicon on Insulator »), il est connu de coller un premier substrat semi-conducteur sur un second substrat, semi-conducteur ou non, la surface d'au moins l'un desdits substrats étant recouverte d'une couche d'oxyde de sorte à réaliser un collage oxyde / semi-conducteur ou oxyde / oxyde.

Le collage par adhésion moléculaire ne nécessite l'application d'aucun adhésif ; les surfaces à coller étant parfaitement lisses, le collage est généralement initié par l'application localisée d'une légère pression sur les substrats, qui génère une onde de collage qui se propage ensuite sur toute l'étendue de l'interface de collage.

Cependant, il a été identifié que le procédé de collage pouvait être à l'origine de défauts de type « picots » (« edge voids » selon la terminologie anglo-saxonne) dans les substrats de type semi-conducteur sur isolant. Ces défauts apparaissent lorsque, après le collage, on transfère une couche mince du premier substrat (également appelé substrat donneur) vers le second substrat (également appelé substrat receveur), par exemple en détachant le premier substrat le long d'une zone de fragilisation préalablement formé dans ledit substrat. Ce procédé de transfert de couche est connu sous le nom de procédé Smart Cut^{™}.

Les picots sont des trous qui s'étendent au travers de la couche mince transférée et de la couche d'oxyde située à l'interface de collage. Ces trous présentent typiquement un diamètre de 50 µm à 2 mm et sont situés généralement à la périphérie du substrat semi-conducteur sur isolant.

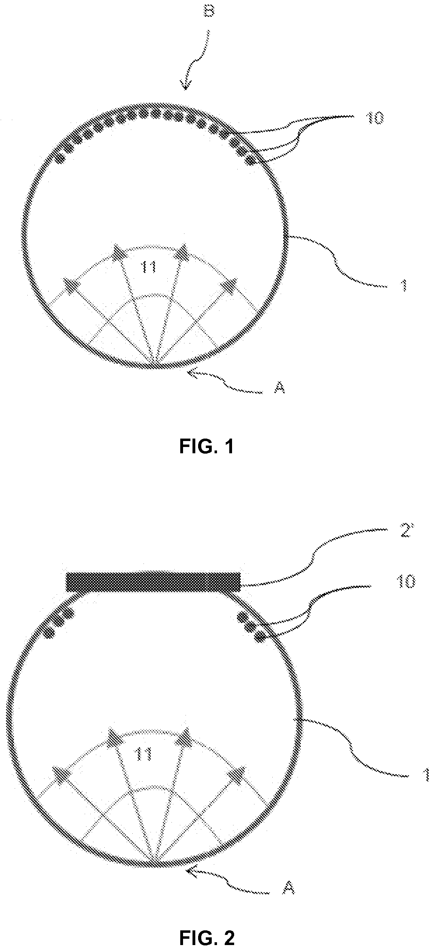

Comme illustré sur la figure 1, qui illustre en vue de dessus la surface de la couche mince transférée 1 d'un substrat SOI, lorsque le collage est initié sur un bord des substrats à coller (zone A), les picots sont généralement générés sur le bord opposé, dans la zone B dans laquelle la propagation de l'onde de collage 11 se termine.

Les picots sont donc des défauts graves et souvent rédhibitoires, dans la mesure où un composant électronique formé dans ou sur une région de la couche mince transférée comprenant un tel picot est défectueux.

Le document WO 2008/107029 décrit un procédé de collage d'un premier substrat et d'un second substrat, dans lequel, pour limiter la formation de tels picots, on chauffe au moins un des substrats avant et pendant la mise en contact desdits substrats, de sorte à contrôler la vitesse de propagation de l'onde de collage.

Ce chauffage est localisé à la zone périphérique dans laquelle se concentrent les picots, et est mis en oeuvre au moyen d'une lampe halogène disposée dans un boîtier en quartz en regard de ladite zone.

Cependant, le chauffage tend à dégrader le support (« chuck » selon la terminologie anglo-saxonne) qui maintient les substrats pendant le collage. En effet, ce support est formé d'une semelle métallique recouverte d'un revêtement polymère, qui se désolidarise de la semelle et se déforme en formant des cloques sous l'effet d'un chauffage trop intense. Or, cet endommagement du support est susceptible de générer d'autres défauts, notamment des zones non collées, dans le substrat final.

Si l'on cherche à réduire l'endommagement du support en diminuant la durée ou l'intensité du chauffage, la vitesse de propagation de l'onde de collage risque d'être insuffisamment contrôlée et de conduire à la formation de picots.

Par ailleurs, ce procédé souffre d'un manque de stabilité au cours du temps et est donc peu reproductible.

Le document EP 1964166 divulgue également un procédé de collage d'un premier substrat et d'un deuxième substrat selon l'art antérieur.

### Brève description de l'invention

Un but de l'invention est donc de définir un procédé de collage de substrats qui permette de minimiser la formation de picots tout en étant plus stable et plus reproductible que le procédé existant, et qui n'engendre pas de détérioration du support des substrats.

A cet effet, l'invention propose un procédé de collage d'un premier substrat et d'un second substrat, comprenant la mise en contact desdits premier et second substrats et la mise en oeuvre d'un chauffage d'une zone périphérique d'au moins un desdits premier et second substrats, ledit chauffage étant initié avant la mise en contact des substrats et prolongé au moins jusqu'à la mise en contact des substrats dans ladite zone, ledit procédé étant caractérisé en ce que le chauffage est mis en oeuvre au moyen d'une lampe infrarouge configurée pour émettre un rayonnement présentant une limite extérieure correspondant au bord desdits substrats.

De par le type de rayonnement et l'agencement de la lampe par rapport aux substrats, il est possible de chauffer plus efficacement l'eau présente à l'interface de collage, qui influe fortement sur la cinétique de collage, avec une puissance réduite, tout en réduisant l'échauffement des substrats et en particulier du support desdits substrats.

Dans certains modes de réalisation, les premier et second substrats présentent une forme circulaire et la lampe infrarouge présente une forme en arc de cercle dont le diamètre est inférieur ou égal au diamètre desdits substrats.

Dans certains modes de réalisation, le premier et le second substrat sont maintenus par un support présentant une région périphérique s'étendant autour du bord desdits substrats, la lampe infrarouge étant agencée de sorte à chauffer la zone périphérique du premier et/ou du second substrat à l'exclusion de la région périphérique dudit support.

De manière particulièrement avantageuse, le chauffage se termine au plus tard à la fin de la propagation de l'onde de collage entre les substrats.

Selon un mode de réalisation préféré, la lampe infrarouge émet un rayonnement dans une gamme de longueur d'onde adapté pour une absorption dudit rayonnement par de l'eau présente entre les substrats.

Un autre objet de l'invention concerne un procédé de fabrication d'un substrat de type semi-conducteur sur isolant, par transfert d'une couche semi-conductrice d'un premier substrat semi-conducteur, dit substrat donneur, sur un second substrat, dit substrat receveur, comprenant :
- la formation d'une zone de fragilisation dans le substrat donneur, de sorte à délimiter une couche semi-conductrice à transférer,
- la fourniture d'un substrat receveur, l'un au moins du substrat donneur et du substrat receveur étant recouvert d'une couche électriquement isolante,
- le collage du premier substrat et du substrat receveur par le procédé tel que décrit plus haut, la couche électriquement isolante étant à l'interface de collage,
- le détachement du substrat donneur le long de la zone de fragilisation, de sorte à transférer la couche semi-conductrice sur le substrat receveur.

Un autre objet de l'invention concerne une installation permettant la mise en œuvre de ce procédé.

Ladite installation comprend un support configuré pour maintenir les premier et second substrats lors de leur mise en contact, ledit support présentant une région périphérique s'étendant autour du bord desdits substrats, et une lampe agencée en regard d'une zone périphérique d'au moins un desdits premier et second substrats, et est caractérisée en ce que la lampe est une lampe infrarouge configurée pour émettre un rayonnement présentant une limite extérieure correspondant au bord desdits substrats, de sorte à ne pas exposer la région périphérique du support audit rayonnement.

Selon un mode de réalisation, la lampe infrarouge est adaptée pour émettre une onde de type moyenne rapide. On entend par là que la longueur d'onde du rayonnement émis est supérieure à 1 µm.

Dans certains modes de réalisation, la lampe infrarouge comprend un filament adapté pour être porté à une température d'environ 1600°C lors du fonctionnement de la lampe.

De manière avantageuse, la lampe infrarouge présente un pic de puissance pour une longueur d'onde comprise entre 1,5 et 2 µm. Ainsi, la lampe favorise l'absorption du rayonnement par l'eau plus que par le matériau semi-conducteur, ce qui permet de réduire l'échauffement du support et prévient la formation des défauts susceptibles d'en découler.

### Brève description des dessins

D'autres caractéristiques et avantages de l'invention ressortiront de la description détaillée qui va suivre, en référence aux dessins annexés sur lesquels :
- la figure 1 est une vue de la surface d'un substrat SOI, représentant schématiquement la propagation de l'onde de collage et la formation de picots ;
- la figure 2 est une vue de la surface d'un substrat SOI, sur laquelle la lampe halogène telle que décrite dans le document WO 2008/107029 a été schématisée ;
- la figure 3 est une vue de la surface d'un substrat SOI, sur laquelle une lampe infrarouge selon l'invention a été schématisée ;
- la figure 4 est un graphique présentant les spectres d'émission d'une lampe halogène et d'une lampe infrarouge, ainsi que le spectre d'absorption de l'eau en fonction de la longueur d'onde ;
- la figure 5 illustre de manière schématique un substrat maintenu sur un support en vue de l'étape de collage ;
- la figure 6 présente des images d'une cartographie de la température du support des substrats pendant le chauffage par une lampe infrarouge selon l'invention (image de gauche) et par une lampe halogène (image de droite) ;
- la figure 7 est une vue de la surface d'un substrat SOI avec des picots formés dans une zone insuffisamment chauffée par la lampe halogène dans le procédé de collage connu ;
- la figure 8A est une vue en coupe de la formation d'une zone de fragilisation au sein d'un substrat donneur ;
- la figure 8B est une vue en coupe du collage du substrat donneur de la figure 8A sur un substrat receveur ;
- la figure 8C est une vue en coupe du détachement du substrat donneur le long de la zone de fragilisation de sorte à transférer une couche semi-conductrice du substrat donneur sur le substrat receveur.

Pour des raisons de lisibilité des figures, les différentes couches des substrats et/ou les composants de l'installation n'ont pas nécessairement été représentés à l'échelle.

### Description détaillée de modes de réalisation

L'invention propose de modifier non seulement la source de chauffage mais aussi la forme de ladite source.

Dans l'état de la technique, la lampe halogène se présente sous la forme d'un barreau rectiligne. Cependant, les substrats présentant habituellement une forme circulaire, la lampe halogène n'irradie qu'une partie de la périphérie des substrats.

Comme illustré sur la figure 2, la lampe 2' est agencée tangentiellement au bord des substrats, du côté opposé à la zone A dans laquelle l'onde de collage est initiée. Du fait de sa largeur, la lampe 2' illumine une bande des substrats s'étendant depuis le bord vers le centre des substrats. Cette bande correspond à une portion de corde qui coupe le bord des substrats en deux zones, lesdites zones d'intersection étant espacées d'un angle d'environ 60°.

Or, les picots s'étendent typiquement sur un secteur angulaire de 120° en regard de la zone d'initiation de l'onde de collage.

Il en résulte, comme schématisé sur la figure 2, que des picots 10 subsistent de part et d'autre de la zone périphérique illuminée par la lampe 2'.

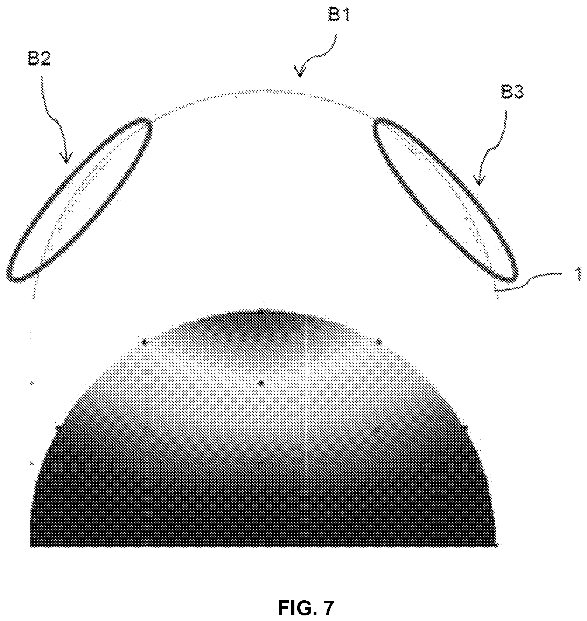

Ces picots restants sont mis en évidence sur la figure 7.

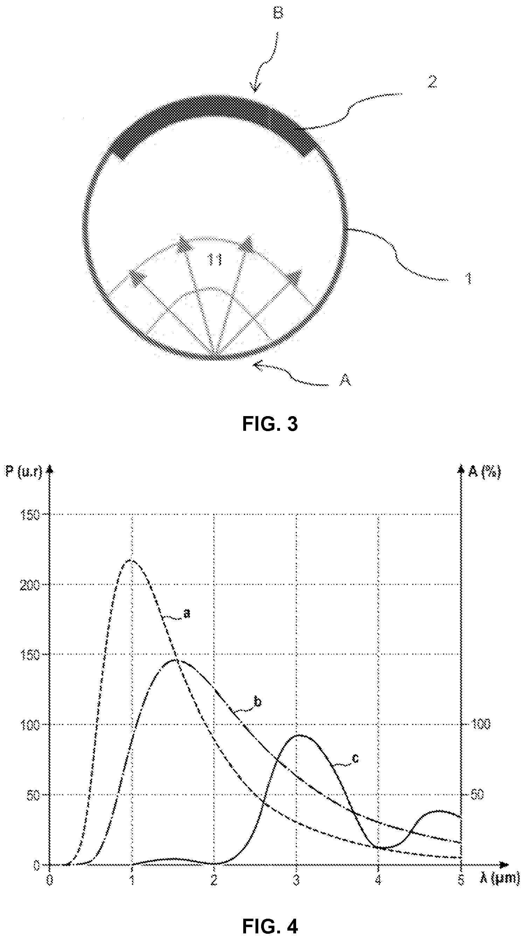

En référence à la figure 3, il est proposé une lampe 2 configurée pour émettre un rayonnement présentant une limite extérieure correspondant au bord desdits substrats.

En d'autres termes, dans le cas de substrats circulaires, la lampe 2 présente une forme en arc de cercle dont le diamètre est inférieur ou égal au diamètre desdits substrats. La longueur de la lampe est choisie pour occuper un secteur angulaire de l'ordre de 120° en regard de la périphérie des substrats.

Ainsi, la lampe 2 illumine l'ensemble ou tout au moins la majeure partie de la zone dans laquelle les picots sont susceptibles de se produire. En outre, la lampe n'illumine que la zone à traiter, à l'exclusion d'autres zones des substrats et du support servant à maintenir les substrats, ce qui évite ou minimise l'endommagement de celui-ci par la chaleur générée.

Par ailleurs, la lampe 2 n'est pas une lampe halogène mais une lampe infrarouge.

De manière connue en elle-même, la lampe infrarouge comprend un filament électriquement conducteur, généralement en tungstène, agencé dans un tube transparent au rayonnement infrarouge, par exemple un tube de quartz. Traversé par un courant électrique, le filament est porté à une température élevée et émet un rayonnement infrarouge. De manière avantageuse, la lampe comprend un réflecteur agencé le long du filament afin de diriger le rayonnement dans une direction privilégiée.

De préférence, la lampe infrarouge est choisie parmi les lampes émettant des ondes moyennes rapides. Dans une telle lampe, le filament est porté à une température d'environ 1600°C.

Par rapport à une lampe halogène, la lampe infrarouge présente deux avantages significatifs.

D'une part, elle permet une plus grande stabilité du chauffage au cours du temps, ce qui procure une plus grande répétabilité et une meilleure fiabilité du procédé de collage.

D'autre part, elle émet un rayonnement dans une gamme de longueur d'onde supérieure à celle de la lampe halogène, plus favorable à la maîtrise de la vitesse de l'onde de collage tout en étant moins violente pour les substrats et le support sous-jacent.

La figure 4 est un graphique présentant les spectres d'émission d'une lampe halogène utilisée dans le procédé de collage connu (courbe a) et d'une lampe infrarouge utilisée dans le procédé de collage selon l'invention (courbe b), ainsi que le spectre d'absorption de l'eau (courbe c) en fonction de la longueur d'onde λ. L'axe des ordonnées de gauche représente la puissance P du rayonnement (en unités relatives u.r) émis par les deux lampes et l'axe des ordonnées de droite représente le coefficient absorption A (en %) de l'eau.

On s'intéresse à l'absorption desdits rayonnements dans l'eau car l'eau est fortement impliquée dans la cinématique de collage des substrats. En effet, une faible quantité d'eau (de l'ordre de quelques monocouches) adsorbée à la surface des substrats est nécessaire pour assurer l'adhésion des substrats par des forces de Van der Waals. En revanche, une quantité d'eau trop importante diminue l'énergie de collage. Le chauffage procuré par la lampe doit donc être suffisamment intense pour évacuer l'eau en excès tout en conservant une quantité d'eau adsorbée à la surface des substrats suffisante.

On observe que le pic de puissance de la lampe infrarouge se situe à une longueur d'onde plus élevée (entre 1,5 et 2 µm) que le pic de puissance de la lampe halogène (qui est de l'ordre de 1 µm), de sorte que l'eau absorbe de manière plus importante le rayonnement émis par la lampe infrarouge que par la lampe halogène (l'eau présentant une absorption significative dans une gamme comprise entre 2,5 et 3,7 µm).

A contrario, le rayonnement de la lampe halogène est davantage absorbé par le silicium des substrats, ce qui d'une part est moins utile au contrôle de l'énergie de collage et d'autre part contribue à échauffer par conduction le support maintenant les substrats.

Par ailleurs, la puissance de la lampe infrarouge est inférieure à celle de la lampe halogène.

On notera que, bien que la lampe halogène émette dans le proche infrarouge en plus du domaine visible, elle ne doit pas être assimilée à une lampe infrarouge selon l'invention. En effet, le rayonnement d'une lampe infrarouge dans le domaine visible est négligeable ; en d'autres termes, la lampe infrarouge émet un rayonnement essentiellement thermique.

La température du filament de la lampe halogène (de l'ordre de 2600°C) est supérieure à celle du filament de la lampe infrarouge qui, comme indiqué plus haut, est de l'ordre de 1600°C.

L'adaptation de la forme de la lampe à la forme des substrats peut être réalisée en utilisant un tube courbe allongé contenant un filament dont le rayon de courbure est identique à celui des substrats, ou en juxtaposant plusieurs tubes selon une courbe dont le rayon de courbure est identique à celui des substrats.

Le changement de technologie et de forme de lampe permet donc de réduire l'endommagement thermique du support.

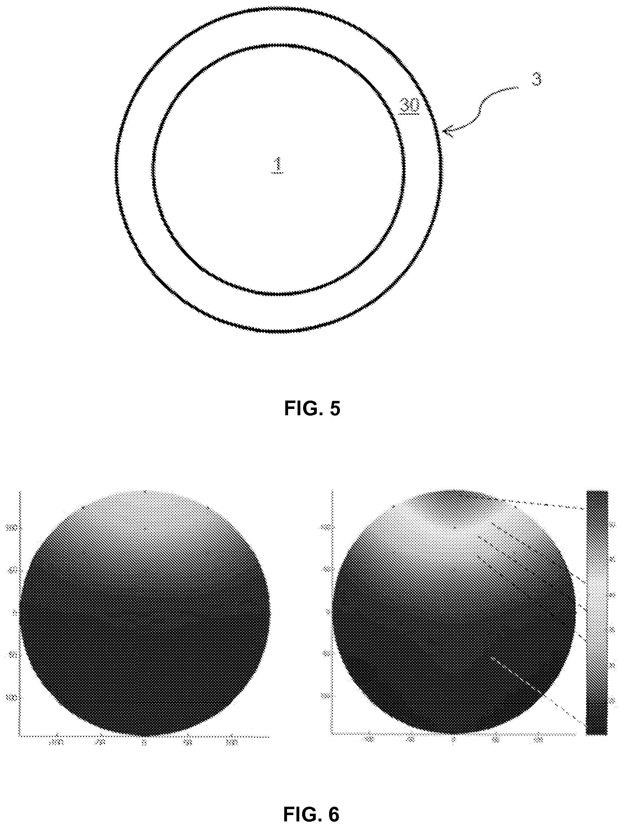

Le support est représenté de manière schématique en vue de dessus sur la figure 5, en situation de maintien des substrats à coller. Le support 3 comporte une partie centrale recouverte par les substrats et une partie périphérique 30 s'étendant autour des substrats et comprenant éventuellement des moyens de fixation des substrats (non représentés). On comprend qu'avec la lampe halogène rectiligne de l'état de la technique, cette partie périphérique était directement chauffée par le rayonnement de la lampe. Au contraire, la lampe infrarouge selon l'invention ne s'étendant pas au-dessus de cette partie périphérique 30, le rayonnement infrarouge n'échauffe pas directement ladite partie 30.

Par ailleurs, l'effet plus favorable sur le support est visible sur la figure 6 qui présente des images d'une cartographie de la température du support des substrats pendant le chauffage desdits substrats par une lampe infrarouge selon l'invention (image de gauche) et par une lampe halogène selon l'état de la technique (image de droite). Cette cartographie a été obtenue grâce à des thermocouples (schématisés par les points noirs) agencés sur la partie centrale du support, sous les substrats.

Avec la lampe halogène, la température atteinte sur le support est plus élevée (de l'ordre de 50 à 55°C) qu'avec la lampe infrarouge (de l'ordre de 35 à 40°C). Cette différence de température est suffisante pour améliorer la longévité du support.

La figure 7 est une image de la surface d'un substrat SOI avec des picots formés dans des zones insuffisamment chauffée par la lampe halogène dans le procédé de collage connu. La cartographie de température affichée sous cette image est celle de la partie droite de la figure 6. On observe que la région B1 qui a été effectivement chauffée par la lampe halogène, à savoir la partie la plus chaude, est dépourvue de picots. En revanche, dans les régions B2, B3 entourées s'étendant de part et d'autre de la région B1, qui n'étaient pas agencées directement sous la lampe halogène, il subsiste des picots.

En pratique, une installation industrielle pour le collage des substrats peut comprendre un bâti supportant le support des substrats et la lampe infrarouge.

De manière avantageuse, le support est agencé dans un plan horizontal et la lampe infrarouge s'étend dans un plan parallèle à celui du support, au-dessus de celui-ci.

La distance entre la lampe et le support est suffisamment grande pour permettre la manipulation des substrats et pour ne pas perturber le flux laminaire appliqué dans l'équipement pour éviter la présence de contaminants. En pratique, la distance entre la lampe et le support peut être de l'ordre de 20 cm.

La forme de la lampe est adaptée à celle des substrats à coller. Par exemple, lorsque les substrats à coller présentent un diamètre de 300 mm, la lampe présente un rayon de courbure de 150 mm au maximum, de préférence de l'ordre de 145 mm ou moins.

Le réflecteur de la lampe est agencé de manière à diriger le rayonnement infrarouge vers les substrats.

Du fait de la forme et de l'agencement de la lampe, le rayonnement infrarouge a une limite extérieure qui correspond au bord des substrats, de sorte que la région périphérique du support, qui s'étend radialement au-delà du bord des substrats, n'est pas exposée audit rayonnement.

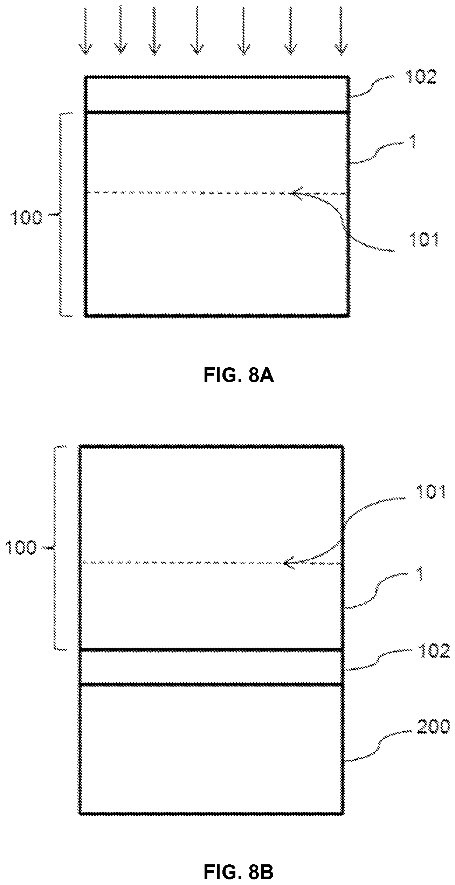

Les figures 8A à 8C illustrent des étapes d'un procédé de transfert de couche de type Smart Cut^{™} mettant en œuvre le procédé de collage décrit ci-dessus.

En référence à la figure 8A, on fournit un substrat donneur 100 comprenant au moins une couche semi-conductrice. Ledit substrat peut être massif ou se présenter sous la forme d'un empilement de couches de différents matériaux.

Le substrat 100 peut être recouvert d'une couche diélectrique 102, par exemple une couche d'oxyde de silicium.

On met en œuvre une implantation d'espèces atomiques, telles que de l'hydrogène et/ou de l'hélium, dans le substrat donneur 100 au travers de la couche diélectrique 102. On forme ainsi dans le substrat donneur une zone de fragilisation 101 délimitant une couche semi-conductrice 1 à transférer.

En référence à la figure 8B, on colle le substrat donneur 100 ainsi fragilisé sur un substrat receveur 200. Le collage est réalisé par l'intermédiaire de la couche diélectrique 102, le substrat receveur pouvant éventuellement être recouvert également d'une couche diélectrique (pour un collage oxyde / oxyde) ou non (pour un collage oxyde / semi-conducteur). De manière alternative, la couche diélectrique peut être présente sur le substrat receveur uniquement (pour un collage semi-conducteur / oxyde).

Pour mettre en œuvre ce collage, les substrats sont maintenus sur un support (non représenté) et une lampe infrarouge est agencée à l'opposé du support par rapport aux substrats, en regard de la zone périphérique dans laquelle la propagation de l'onde de collage doit se terminer. On initie une onde de collage entre les substrats par application localisée d'une légère pression sur les substrats, au niveau du bord opposé à l'emplacement de la lampe.

La lampe infrarouge est allumée au plus tard au moment de la mise en contact des substrats, et est éteinte au plus tard lors de la fermeture complète de l'interface entre les substrats. De manière avantageuse, l'allumage de la lampe est asservi sur le mouvement du dispositif qui applique sur les substrats la pression nécessaire à l'initiation du collage. L'extinction de la lampe peut être commandée à l'issue d'une durée prédéterminée après l'allumage. Cette durée est préalablement calibrée, pour chaque ensemble de substrats à coller, par une mesure de la vitesse de l'onde de collage entre lesdits substrats.

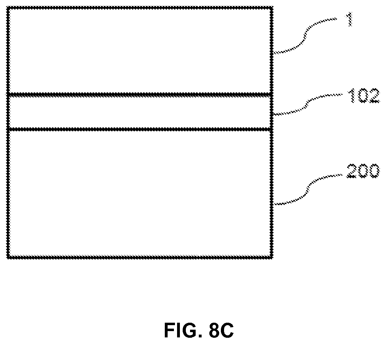

Enfin, en référence à la figure 8C, on détache le substrat donneur 100 le long de la zone de fragilisation 101, ce qui conduit à transférer la couche 1 sur le substrat receveur. Grâce au procédé de collage mis en œuvre, la couche transférée 1 est sensiblement dépourvue de picots. Par ailleurs, le support n'ayant pas été endommagé par le chauffage, la couche 1 transférée est également exempte de la défectivité liée au support, telle que des zones non collées.

## Revendications

1. Procédé de collage d'un premier substrat (100) et d'un second substrat (200), comprenant la mise en contact desdits premier et second substrats et la mise en oeuvre d'un chauffage d'une zone périphérique d'au moins un desdits premier et second substrats, ledit chauffage étant initié avant la mise en contact des substrats et prolongé au moins jusqu'à la mise en contact des substrats dans ladite zone, ledit procédé étant **caractérisé en ce que** le chauffage est mis en oeuvre au moyen d'une lampe infrarouge (2) configurée pour émettre un rayonnement présentant une limite extérieure correspondant au bord desdits substrats.

2. Procédé selon la revendication 1, dans lequel les premier et second substrats présentent une forme circulaire et la lampe infrarouge présente une forme en arc de cercle dont le diamètre est inférieur ou égal au diamètre desdits substrats.

3. Procédé selon l'une des revendications 1 ou 2, dans lequel le premier et le second substrat sont maintenus par un support (3) présentant une région périphérique (30) s'étendant autour du bord desdits substrats, la lampe infrarouge (2) étant agencée de sorte à chauffer la zone périphérique du premier et/ou du second substrat à l'exclusion de la région périphérique (30) dudit support.

4. Procédé selon l'une des revendications 1 à 3, dans lequel le chauffage se termine au plus tard à la fin de la propagation de l'onde de collage entre les substrats.

5. Procédé selon l'une des revendications 1 à 4, dans lequel la lampe infrarouge (2) émet un rayonnement dans une gamme de longueur d'onde adapté pour une absorption dudit rayonnement par de l'eau présente entre les substrats (100, 200).

6. Procédé de transfert d'une couche semi-conductrice d'un premier substrat semi-conducteur, dit substrat donneur (100), sur un second substrat, dit substrat receveur (200), comprenant :
- la formation d'une zone de fragilisation (101) dans le substrat donneur (100), de sorte à délimiter une couche semi-conductrice (1) à transférer,
- la fourniture d'un substrat receveur (200), l'un au moins du substrat donneur et du substrat receveur étant recouvert d'une couche électriquement isolante (102),
- le collage du premier substrat (100) et du substrat receveur (200) par le procédé selon l'une des revendications 1 à 5, la couche électriquement isolante (102) étant à l'interface de collage,
- le détachement du substrat donneur (100) le long de la zone de fragilisation (101), de sorte à transférer la couche semi-conductrice (1) sur le substrat receveur (200).

7. Installation pour le collage d'un premier substrat et d'un second substrat, comprenant un support (3) configuré pour maintenir lesdits premier et second substrats lors de leur mise en contact, ledit support présentant une région périphérique (30) s'étendant autour du bord desdits substrats, et une lampe agencée en regard d'une zone périphérique d'au moins un desdits premier et second substrats, ladite installation étant **caractérisée en ce que** la lampe est une lampe infrarouge (2) configurée pour émettre un rayonnement présentant une limite extérieure correspondant au bord desdits substrats, de sorte à ne pas exposer la région périphérique (30) du support (3) audit rayonnement.

8. Installation selon la revendication 7, dans laquelle la lampe infrarouge est adaptée pour émettre une onde de type moyenne rapide.

9. Installation selon l'une des revendications 7 ou 8, dans laquelle la lampe infrarouge comprend un filament adapté pour être porté à une température d'environ 1600°C lors du fonctionnement de la lampe.

10. Installation selon l'une des revendications 7 à 9, dans laquelle la lampe infrarouge présente un pic de puissance pour une longueur d'onde comprise entre 1,5 et 2 µm.

## Patentansprüche

1. Verfahren zum Verkleben eines ersten Substrats (100) und eines zweiten Substrats (200), umfassend das Inkontaktbringen des ersten und des zweiten Substrats und das Erwärmen eines Randbereichs mindestens eins von dem ersten und dem zweiten Substrat, wobei die Erwärmung vor dem Inkontaktbringen der Substrate eingeleitet und mindestens bis zum Inkontaktbringen der Substrate in dem Bereich fortgesetzt wird, wobei das Verfahren **dadurch gekennzeichnet ist, dass** die Erwärmung mittels einer Infrarotlampe (2) durchgeführt wird, die so konfiguriert ist, dass sie eine Strahlung sendet, die eine Außengrenze aufweist, die dem Rand der Substrate entspricht.

2. Verfahren nach Anspruch 1, wobei das erste und das zweite Substrat eine kreisförmige Form aufweisen und die Infrarotlampe eine bogenförmige Form aufweist, deren Durchmesser kleiner oder gleich dem Durchmesser der Substrate ist.

3. Verfahren nach einem der Ansprüche 1 oder 2, wobei das erste und das zweite Substrat von einer Halterung (3) gehalten werden, die einen Randbereich (30) aufweist, der sich um den Rand der Substrate erstreckt, wobei die Infrarotlampe (2) so eingerichtet ist, dass sie den Randbereich des ersten und/oder des zweiten Substrats unter Ausschluss des Randbereichs (30) der Halterung erwärmt.

4. Verfahren nach einem der Ansprüche 1 bis 3, wobei die Erwärmung spätestens am Ende der Ausbreitung der Klebe-Welle zwischen den Substraten endet.

5. Verfahren nach einem der Ansprüche 1 bis 4, wobei die Infrarotlampe (2) Strahlung in einem Wellenlängenbereich sendet, der für eine Absorption der Strahlung durch das zwischen den Substraten (100, 200) vorhandene Wasser geeignet ist.

6. Verfahren zum Übertragen einer Halbleiterschicht von einem ersten Halbleitersubstrat, bezeichnet als Donorsubstrat (100), auf ein zweites Substrat, bezeichnet als Empfängersubstrat (200), umfassend:
- das Bilden einer Schwächungszone (101) in dem Donorsubstrat (100), um eine zu übertragende Halbleiterschicht (1) abzugrenzen,
- das Bereitstellen eines Empfängersubstrats (200), wobei mindestens eins von dem Donorsubstrat und dem Empfängersubstrat mit einer elektrisch isolierenden Schicht (102) bedeckt ist,
- das Verkleben des ersten Substrats (100) und des Empfängersubstrats (200) durch das Verfahren nach einem der Ansprüche 1 bis 5, wobei sich die elektrisch isolierende Schicht (102) an der Klebeschnittstelle befindet,
- das Ablösen des Donorsubstrats (100) entlang der Schwächungszone (101), um die Halbleiterschicht (1) auf das Empfängersubstrat (200) zu übertragen.

7. Anlage zum Verkleben eines ersten Substrats und eines zweiten Substrats, umfassend eine Halterung (3), die so konfiguriert ist, dass sie das erste und das zweite Substrat bei ihrem Inkontaktbringen hält, wobei die Halterung einen Randbereich (30) aufweist, der sich um den Rand der Substrate herum erstreckt, und eine Lampe, die einem Randbereich von mindestens einem von dem ersten und dem zweiten Substrat zugewandt eingerichtet ist, wobei die Anlage **dadurch gekennzeichnet ist, dass** die Lampe eine Infrarotlampe (2) ist, die so konfiguriert ist, dass sie eine Strahlung sendet, die eine Außengrenze aufweist, die dem Rand der Substrate entspricht, so dass der Randbereich (30) der Halterung (3) der Strahlung nicht ausgesetzt wird.

8. Anlage nach Anspruch 7, wobei die Infrarotlampe geeignet ist, eine Welle vom Typ mittlere schnelle Welle zu senden.

9. Anlage nach einem der Ansprüche 7 oder 8, wobei die Infrarotlampe einen Glühfaden umfasst, der dazu geeignet ist, während des Betriebs der Lampe auf eine Temperatur von etwa 1600°C gebracht zu werden.

10. Anlage nach einem der Ansprüche 7 bis 9, wobei die Infrarotlampe eine Leistungsspitze bei einer Wellenlänge zwischen 1,5 und 2 µm aufweist.

## Claims

1. A method of bonding a first substrate (100) and a second substrate (200), comprising bringing said first and second substrates into contact and applying heat to a peripheral region of at least one of said first and second substrates, said heating being initiated before the substrates come into contact and continued at least until the substrates come into contact in said region, said method being **characterised in that** the heating is carried out by means of an infrared lamp (2) configured to emit radiation having an outer boundary corresponding to the edge of said substrates.

2. The method according to claim 1, wherein the first and second substrates are circular in shape and the infrared lamp is in the shape of an arc of a circle whose diameter is less than or equal to the diameter of said substrates.

3. The method according to one of claims 1 or 2, wherein the first and second substrates are held by a support (3) having a peripheral region (30) extending around the edge of said substrates, the infrared lamp (2) being arranged so as to heat the peripheral region of the first and/or second substrate, excluding the peripheral region (30) of said support.

4. The method according to one of claims 1 to 3, wherein the heating ceases at the latest upon completion of the propagation of the bonding wave between the substrates.

5. The method according to one of claims 1 to 4, wherein the infrared lamp (2) emits radiation in a wavelength range suitable for absorption of said radiation by water present between the substrates (100, 200).

6. A method for transferring a semiconductor layer from a first semiconductor substrate, referred to as the donor substrate (100), onto a second substrate, referred to as the receiver substrate (200), comprising:
- forming a weakening zone (101) in the donor substrate (100), so as to delimit a semiconductor layer (1) to be transferred,
- providing a receiver substrate (200), at least one of the donor substrate and the receiver substrate being coated with an electrically insulating layer (102),
- bonding the first substrate (100) and the receiver substrate (200) by the method according to one of claims 1 to 5, the electrically insulating layer (102) being at the bonding interface,
- detaching the donor substrate (100) along the weakening zone (101), so as to transfer the semiconductor layer (1) onto the receiver substrate (200).

7. An apparatus for bonding a first substrate and a second substrate, comprising a support (3) configured to hold said first and second substrates when they are brought into contact, said support having a peripheral region (30) extending around the edge of said substrates, and a lamp positioned opposite a peripheral region of at least one of said first and second substrates, said apparatus being **characterised in that** the lamp is an infrared lamp (2) configured to emit radiation having an outer boundary corresponding to the edge of said substrates, so as not to expose the peripheral region (30) of the support (3) to said radiation.

8. The apparatus according to claim 7, wherein the infrared lamp is adapted to emit a fast-medium wave.

9. The apparatus according to one of claims 7 or 8, wherein the infrared lamp comprises a filament adapted to be heated to a temperature of approximately 1600°C during operation of the lamp.

10. The apparatus according to one of claims 7 to 9, wherein the infrared lamp has a power peak at a wavelength of between 1.5 and 2 µm.
